# DEMANDE DE BREVET EUROPEEN

(11) **EP 1 821 109 A1**
(43) Date de publication de la demande: **22.08.2007**
(21) Numéro de dépôt: 07300784.1
(22) Date de dépôt: 08.02.2007
(51) Int. Cl.: G01R 31/04, G01R 31/28

(54) **Procédé et dispositif de caractérisation des limites thermiques d'un organe de raccordement électrique**

(30) Priorité: 16.02.2006 FR 0650546
(71) Demandeur: Peugeot Citroen Automobiles, 78140 Velizy-Villacoublay (FR)
(72) Inventeur: Burguburu, Philippe, 78000, VERSAILLES (FR)
(74) Mandataire: Vigand, Régis Louis Michel

(57) **Abrégé**

- L'organe de raccordement comporte une embase à caractériser équipée d'au moins une languette, et selon ce procédé :
- on place deux exemplaires de l'embase (2, 2') à caractériser de telle manière que l'on réalise une symétrie thermique et on met en regard deux à deux les languettes respectives correspondantes (8a, 8b, 8'a, 8'b) de l'un et l'autre exemplaire d'embase, et
- on relie par soudure les extrémités desdites languettes (8a, 8b, 8'a, 8'b) deux à deux sur une longueur (L) qui correspond à celle de la fixation de la languette en fonctionnement normal de l'organe de raccordement électrique, et
- on procède ensuite aux mesures de caractérisation, après avoir relié les parties avant des languettes (4a, 4b, 4'a, 4'b) aux fils (3a, 3b, 3'a, 3'b) du faisceau électrique raccordé.

- Electronique. Connectique. Electronique embarquée à bord de véhicules automobiles.

## Description

La présente invention concerne un procédé et un dispositif de caractérisation des limites thermiques d'un organe de raccordement électrique.

Par caractérisation, on entend, de manière classique, la vérification de la conformité d'un produit (un connecteur dans le cas présent) à ses spécifications au moyen d'un ensemble de tests physiques et électriques.

La caractérisation trouve une application très importante et très utilisée dans « l'allègement de régime » ou « derating », qui est le choix des conditions de fonctionnement d'un matériel, largement en deçà des conditions limites, de façon à réduire les contraintes et augmenter ainsi la fiabilité et la durée de vie du matériel.

Ainsi, le choix d'un organe de raccordement électrique entre, par exemple, une carte électronique et un faisceau électrique requiert la connaissance du profil de courant qui passe dans les lignes électriques les plus chargées en intensité.

Il est connu que, jusqu'à présent, le choix des caractéristiques dimensionnelles des lignes les plus chargées en intensité se faisait par continuité des caractéristiques utilisées pour les interconnexions de ces lignes dans le reste de l'architecture où ces lignes étaient utilisées. Toutefois, l'expérience montre qu'un tel choix, selon ces principes, peut conduire, dans des cas limites, à une fiabilité moins élevée au niveau des interconnexions dans la zone des cartes électroniques qu'au niveau des interconnexions en pleine longueur des faisceaux constitutifs des lignes électriques.

Une analyse plus précise montre que les connexions des liaisons dans la zone des cartes, appelées « embases » dans la présente description, présentent des éléments de contact qui, toutes choses étant égales par ailleurs, travaillent à des températures plus élevées lorsqu'ils sont utilisés pour des embases que lorsqu'ils sont utilisés pour des interconnexions. Cet écart s'explique par le rôle de drain thermique que joue dans toute connectique le fil électrique auquel l'élément de connectique est relié par sertissage ou soudure. En effet, rapporté à la longueur unitaire des conducteurs, un élément de connectique est environ 10 fois plus résistant qu'un élément de fil. Il en résulte que le fil joue un rôle fondamental dans la température d'équilibre d'une liaison électrique, parce qu'il se dégage environ 10 fois plus d'énergie au niveau de la connectique que dans la zone du fil auquel la connectique est reliée. L'étude plus précise des aspects thermiques montre que pour un couple de contact clip/languette, il y a deux fils qui assurent la fonction de drain thermique : à savoir un pour le clip et un pour la languette. Dans le cas d'une embase fixée sur une carte électronique, c'est la carte électronique qui joue le rôle de drain thermique côté languette, et ce drain est le plus souvent nettement moins performant qu'un fil. De plus, les languettes d'embase sont, en général, plus électriquement résistantes que celles utilisées dans les interconnexions sur faisceaux.

Par conséquent, il est important de caractériser l'aptitude d'une embase et des ses éléments de liaison associés à supporter des courants importants.

La fixation de l'embase sur une carte électronique ne peut pas convenir, parce que le paramètre drain thermique n'est pas maîtrisé et varie avec chaque carte électronique.

Une autre solution consiste à souder un fil à la place de la carte électronique, au droit de la languette correspondante. Toutefois, cette solution crée une situation dans laquelle la configuration est trop favorable, le rôle de drain thermique étant alors maximal.

Le but de la présente invention est de concevoir un nouveau procédé de caractérisation des limites thermiques d'un élément de connectique ou organe de raccordement, qui permette d'établir les caractéristiques intrinsèques de chaque voie ou ligne électrique du raccordement, ou des voies de puissance principales, strictement de la même façon que pour une interconnexion sur faisceau.

Un autre but de la présente invention est de concevoir un nouveau procédé de caractérisation des limites thermiques d'un élément de connectique ou organe de raccordement, qui permette de caractériser chaque voie de façon intrinsèque, indépendamment de la largeur des pistes du circuit imprimé de la carte électronique.

Un autre but encore de la présente invention est de réaliser un nouveau montage ou dispositif de caractérisation des limites thermiques d'un élément de connectique ou organe de raccordement, pour la mise en oeuvre du procédé selon la présente invention.

Pour atteindre ces buts, le nouveau procédé de caractérisation des limites thermiques d'un organe de raccordement électrique selon la présente invention s'applique à un organe de raccordement comportant une embase à caractériser équipée d'au moins une languette, et ce nouveau procédé comporte les étapes suivantes :
- on place deux exemplaires de ladite embase à caractériser en position de manière à réaliser une symétrie thermique et à mettre en regard deux à deux les extrémités arrières des languettes respectives correspondantes de l'un et l'autre exemplaires d'embase, et
- on relie lesdites extrémités en regard des languettes sur une longueur qui correspond à celle de la fixation de la languette en fonctionnement normal de l'organe de raccordement électrique, et
- on procède ensuite aux mesures de caractérisation, après avoir relié les languettes aux fils du faisceau électrique raccordé. Les mesures de caractérisation sont des mesures connues et largement utilisées.

La liaison locale des extrémités en regard des languettes est, de préférence, réalisée par soudure.

De préférence, on place les deux exemplaires d'embase en les accolant « dos à dos », de manière à réaliser la symétrie thermique et à mettre en regard les languettes respectives correspondantes de l'un et l'autre exemplaire d'embase.

Selon un mode de réalisation préféré de l'invention, les deux exemplaires d'embase sont accolés « dos à dos » par fixation sur les deux faces d'une carte support, par exemple.

Et, ladite carte support comporte une ouverture destinée au passage des languettes reliées deux à deux.

De préférence, ladite carte support est disposée sensiblement verticalement.

Et, de préférence également, les fils du faisceau électrique reliés audit organe de raccordement sont disposés sensiblement verticalement.

De manière préférentielle, la longueur desdits fils est identique à celle utilisée dans la caractérisation des couples clips et languettes serties sur fils.

Les languettes respectives correspondantes de l'un et l'autre exemplaire d'embase sont, de préférence, des languettes d'une voie de puissance.

Et les mesures de caractérisation, connues en soi, comprennent des mesures de détermination des courbes de « derating ».

La présente invention concerne également un montage ou dispositif de caractérisation des limites thermiques d'un élément de connectique ou organe de raccordement, pour la mise en oeuvre du procédé selon la présente invention.

Ce nouveau dispositif, destiné plus particulièrement à la caractérisation d'un organe de raccordement électrique entre une carte électronique et un faisceau électrique, comporte une carte support, deux embases à caractériser, identiques, fixées dos à dos sur l'une et l'autre face de la carte support, les extrémités arrière des languettes correspondantes des embases étant reliées par soudure deux à deux électriquement et thermiquement sur une longueur qui correspond à celle de la fixation de la languette en fonctionnement normal de l'organe de raccordement électrique, les extrémités avant desdites languettes étant reliées aux fils du faisceau électrique.

La carte support comporte une ouverture destinée au passage des languettes reliées deux à deux.

Et, de préférence, la carte support est disposée sensiblement verticalement, et les fils du faisceau électrique sortent également verticalement.

D'autres avantages et caractéristiques de l'invention apparaîtront dans la description qui suit d'un exemple de réalisation de l'invention, non limitatif de la portée de la présente invention, et accompagnée des dessins annexés dans lesquels :
- la figure 1 représente schématiquement un raccordement électrique d'un faisceau électrique à un circuit imprimé,
- la figure 2 représente schématiquement le montage utilisé pour la mise en oeuvre du procédé, selon la présente invention, de caractérisation de l'organe de raccordement de la figure 1.

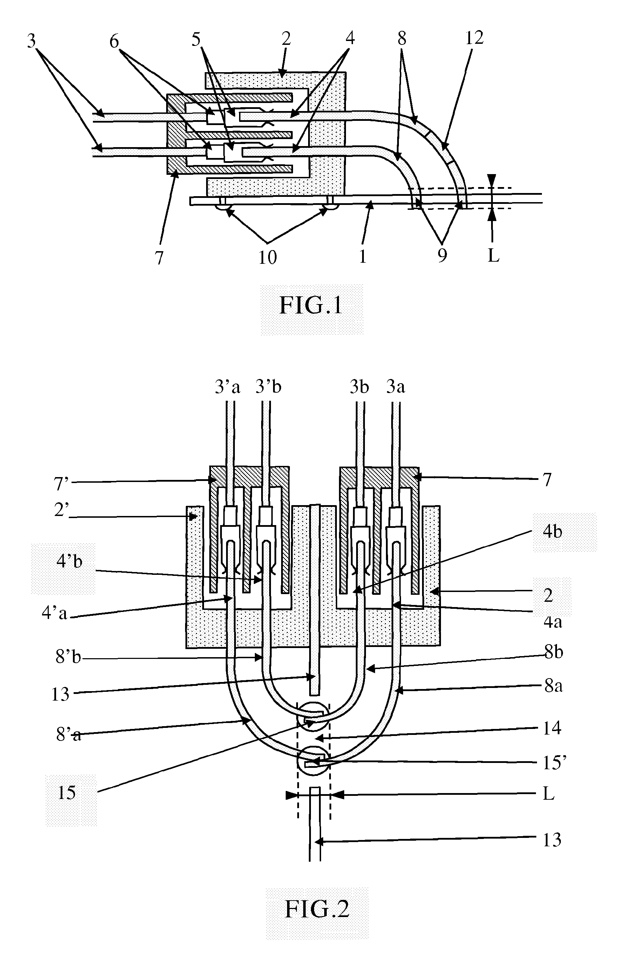

Sur le dessin de la figure 1, est représenté schématiquement un raccordement électrique d'un faisceau électrique à une carte de circuit imprimé. Ce raccordement est réalisé, de manière industrielle, au moyen d'une embase 2, fixée au circuit imprimé 1 par un moyen de fixation 10 connu en soi. L'embase 2 comporte des languettes dont la partie arrière, référencée 8, est reliée au circuit imprimé 1 par un moyen de liaison mécanique et électrique, référencé 9. Ce moyen de liaison 9 peut être un moyen de type soudure ou un moyen de type technologie « press-fit » ou technologie de l'insertion à force, largement utilisée dans le raccordement sur circuits imprimés. Ce moyen de liaison s'étend sur une hauteur référencée L, dont la valeur sera expliquée plus loin dans la présente description. La partie avant, référencée 4, des languettes est en prise avec des clips 5, lesquels sont reliés aux fils 3 d'un faisceau électrique par des sertissages référencés 6. Chaque ensemble constitué par un fil 3 et son clip 5 correspondant est immobilisé et maintenu par un porte clips 7, qui assure également la fonction de liaison mécanique avec l'embase 2.

Selon une caractéristique décrite et revendiquée dans une demande de brevet non encore publiée de la Demanderesse, une ou plusieurs languettes présentent dans leur partie arrière 8, reliée à la carte du circuit imprimé 1, une partie référencée 12 qui est configurée pour faire fonction de fusible, réalisée par exemple en une matière métallique à relativement bas point de fusion. Cette partie 12 faisant fonction de fusible peut être aussi située sur la partie avant 4 de la languette. Cette partie 12 à bas point de fusion est destinée à interrompre le courant circulant dans la languette lorsque celle-ci chauffe anormalement en cas de liaison défectueuse au niveau du moyen de liaison 9 ou au niveau du clip 5 ou encore en cas de court-circuit franc sur la ligne électrique concernée du fil 3 correspondant.

Sur le dessin de la figure 2, on a représenté schématiquement le montage utilisé pour la mise en oeuvre du procédé de caractérisation selon la présente invention.

Ce montage est destiné à la caractérisation des limites thermiques d'un organe de raccordement, tel que celui décrit ci-dessus et représenté sur le dessin de la figure 1. A ce montage est appliqué le procédé, connu en soi et largement utilisé, permettant de déterminer les courbes dites de « derating » qui donnent, pour une section de fil donnée et pour une élévation de température donnée, le courant électrique maximal que chaque voie électrique de l'embase est capable de supporter. La courbe de « derating » indique le courant maximal qui peut, de façon permanente et simultanément, circuler dans les connexions si le composant est exposé à la température ambiante en dessous de sa température limite supérieure, définie par les matériaux. La température maximale est calculée à partir de la température ambiante et à partir de l'échauffement dû à la charge de courant. Le « derating » d'un composant n'est pas une valeur constante, mais décroît avec l'augmentation de la température ambiante du composant. De plus, la capacité de charge de courant dépend de la géométrie, des matériaux employés, du nombre de pôles et de conducteurs.

Deux embases, 2 et 2', identiques, sont disposées de façon symétrique, dos à dos, sur une carte support 13, du même type que la carte de circuit électronique 1 de la figure 1. De manière générale, les mêmes références numériques désignent les mêmes composants des deux embases, à la différence qu'aux références d'une des deux embases (celle de gauche sur le dessin de la figure 2) sont ajoutées le signe « '». Les deux embases, 2 et 2', sont fixées sur la carte support 13 par un moyen de fixation connu en soi, et non représenté. Ce mode de positionnement symétrique des embases 2 et 2' sur la carte support 13 permet de réaliser une symétrie thermique.

D'autres modes de positionnement sont concevables pour obtenir une disposition symétrique des embases, la disposition décrite et représentée sur le dessin de la figure 2 constituant un mode préféré de positionnement, et par là même un mode de réalisation préféré de l'invention, non limitatif de l'objet de la présente invention.

C'est également à titre d'exemple que sont représentées, sur le dessin de la figure 2, des embases 2 et 2' qui présentent chacune deux languettes, qui sont ici des languettes de puissance superposées. La présente invention s'applique également à des embases comportant un nombre différent de languettes ou encore à des embases dont l'axe principal des languettes est perpendiculaire au plan du circuit imprimé.

Les extrémités des parties arrière, 8a et 8b pour l'embase 2 ainsi que 8'a et 8'b pour l'embase 2', des languettes de l'une et de l'autre embase, 2 et 2', sont reliées entre elles, deux à deux, par soudure référencée 15, 15', respectivement, sur une longueur L correspondante à celle de la hauteur de la liaison mise en oeuvre dans l'utilisation normale de l'embase sur une carte électronique, c'est-à-dire la hauteur L représentée sur le dessin de la figure 1. Ainsi, l'extrémité de la partie arrière de languette 8a est reliée en 15' avec l'extrémité de la partie arrière de languette 8'a tandis que l'extrémité de la partie arrière de languette 8b est reliée en 15 avec l'extrémité de la partie arrière de languette 8'b.

La carte support 13 comporte une ouverture 14 pour le passage des languettes ainsi reliées deux à deux.

Les extrémités avant des languettes, 4a, 4b, 4'a, 4'b, sont reliées aux fils correspondants 3a, 3b, 3'a, 3'b, respectivement, par l'intermédiaire des clips maintenus dans leurs portes clips 7, 7', de manière similaire à celle décrite en relation avec la figure 1.

La carte support 13 est disposée verticalement, et toujours selon le présent mode de réalisation préféré de l'invention, les fils 3a, 3b, 3'a, 3'b du faisceau électrique raccordé sortent également verticalement de façon à se retrouver dans la disposition la plus contraignante sur le plan thermique. La longueur des fils 3a, 3b, 3'a, 3'b, est identique à celle utilisée dans la caractérisation des couples sertis sur les fils constitués chacun par un clip et une languette. De plus, cette disposition permet de faire passer le même courant dans deux languettes adjacentes, comme cela est souvent le cas dans la réalité.

Ainsi, un tel montage permet de mettre en oeuvre un nouveau procédé de caractérisation des limites thermiques d'un organe de raccordement électrique, en particulier un nouveau procédé de caractérisation de l'échauffement des languettes de puissance d'une embase pour le raccordement d'un faisceau électrique de courants élevés sur une carte électronique.

Un tel procédé comporte les étapes suivantes :
- on place, comme illustré à titre d'exemple sur la figure 2, deux exemplaires, 2 et 2', de ladite embase à caractériser de manière à réaliser une symétrie thermique et à mettre en regard deux à deux les languettes respectives correspondantes de l'un et l'autre exemplaire d'embase, à savoir 8a avec 8'a et 8b avec 8'b,
- on relie, comme illustré également à titre d'exemple sur la figure 2, lesdites extrémités desdites languettes sur une longueur L qui correspond à celle de la fixation de la languette en fonctionnement normal de l'embase,
et on procède ensuite aux mesures de caractérisation des limites thermiques de l'embase, après avoir relié les extrémités avant 4a, 4b, 4'a, 4'b, des languettes avec les fils 3a, 3b, 3'a, 3'b, respectivement.

C'est sur le montage de la présente invention que l'on applique la méthode de mesure connue du monde de la connectique pour déterminer les courbes dites de « derating », mentionnées précédemment.

Un avantage du procédé de la présente invention réside dans le fait qu'il permet de caractériser chaque voie ou ligne électrique de façon intrinsèque, indépendamment de la largeur des pistes du circuit imprimé, ces pistes pouvant affecter la caractérisation dans un sens favorable (forte section locale) ou défavorable (faible section locale). Dans tous les cas, toutes choses égales par ailleurs, pour un échauffement donné des languettes, le courant est plus faible pour une embase sur carte électronique que pour une interconnexion de type standard, avec les mêmes sections de languette, les mêmes clips et la même section des fils.

D'autres modes de réalisation que ceux décrits et représentés précédemment peuvent être conçus par l'homme de métier sans sortir du cadre et de la portée de la présente invention.

## Revendications

1. Procédé de caractérisation des limites thermiques d'un organe de raccordement électrique, ledit organe de raccordement comportant une embase à caractériser équipée d'au moins une languette, **caractérisé en ce qu'**on place deux exemplaires de ladite embase (2, 2') à caractériser en position de manière à réaliser une symétrie thermique et à mettre en regard deux à deux les extrémités (8a, 8b , 8'a, 8'b) des languettes respectives correspondantes de l'un et l'autre exemplaire d'embase (2, 2'), **en ce qu'**on relie lesdites extrémités (8a, 8b , 8'a, 8'b) desdites languettes mises en regard sur une longueur (L) qui correspond à celle de la fixation de la languette en fonctionnement normal de l'organe de raccordement électrique, et **en ce qu'**on procède ensuite aux mesures de caractérisation.

2. Procédé de caractérisation selon la revendication 1, **caractérisé en ce qu'**on place lesdits deux exemplaires d'embase (2, 2') en les accolant « dos à dos », de manière à réaliser ladite symétrie thermique et à mettre en regard lesdites languettes respectives correspondantes de l'un et l'autre exemplaire d'embase.

3. Procédé de caractérisation selon l'une quelconque des revendications 1 et 2, **caractérisé en ce que** les deux exemplaires d'embase (2, 2') sont accolés « dos à dos » par fixation sur les deux faces d'une carte support (13).

4. Procédé de caractérisation selon l'une quelconque des revendications 1, 2 et 3, **caractérisé en ce qu'**on relie lesdites extrémités (8a, 8b, 8'a, 8'b) desdites languettes mises en regard deux à deux par soudure (15, 15').

5. Procédé de caractérisation selon la revendication 3, **caractérisé en ce que** ladite carte support (13) comporte une ouverture (14) destinée au passage des extrémités des languettes (8a, 8b , 8'a, 8'b) reliées deux à deux.

6. Procédé de caractérisation selon l'une quelconque des revendications 3 et 5, **caractérisé en ce que** ladite carte support (13) est disposée sensiblement verticalement.

7. Procédé de caractérisation selon l'une quelconque des revendications 1 à 6, **caractérisé en ce que** les fils (3a, 3b, 3'a, 3'b) du faisceau électrique reliés audit organe de raccordement sont disposés sensiblement verticalement.

8. Procédé de caractérisation selon la revendication 1, **caractérisé en ce que** la longueur desdits fils (3a, 3b, 3'a, 3'b) est identique à celle utilisée dans la caractérisation des couples clips et languettes serties sur fils.

9. Procédé de caractérisation selon l'une quelconque des revendications 1 à 8, **caractérisé en ce que** les languettes respectives correspondantes de l'un et l'autre exemplaire (2, 2') d'embase sont des languettes d'une voie de puissance.

10. Procédé de caractérisation selon l'une quelconque des revendications 1 à 9, **caractérisé en ce que** lesdites mesures de caractérisation comprennent des mesures de détermination des courbes de « derating ».

11. Dispositif pour la caractérisation d'un organe de raccordement électrique, notamment d'une embase de raccordement entre une carte électronique et un faisceau électrique, **caractérisé en ce qu'**il comporte une carte support (13), deux embases (2, 2') à caractériser, identiques, fixées dos à dos sur l'une et l'autre face de la carte support, les extrémités arrière des languettes correspondantes (8a, 8b, 8'a, 8'b) des embases étant reliées électriquement et thermiquement sur une longueur (L) qui correspond à celle de la fixation de la languette en fonctionnement normal de l'organe de raccordement électrique, et les extrémités avant desdites languettes (4a, 4b, 4'a, 4'b) étant reliées aux fils (3a, 3b, 3'a, 3'b) du faisceau électrique.

12. Dispositif pour la caractérisation d'un organe de raccordement électrique selon la revendication 11, **caractérisé en ce que** la carte support (13) comporte une ouverture (14) destinée au passage des extrémités des languettes (8a, 8b, 8'a, 8'b) reliées deux à deux.

13. Dispositif pour la caractérisation d'un organe de raccordement électrique selon la revendication 11, **caractérisé en ce que** la carte support (13) est disposée sensiblement verticalement

14. Dispositif pour la caractérisation d'un organe de raccordement électrique selon la revendication 11, **caractérisé en ce que** les fils du faisceau électrique (3a, 3b, 3'a, 3'b) sortent sensiblement verticalement de l'organe de raccordement.
